# DEMANDE DE BREVET EUROPEEN

(11) **EP 4 679 101 A1**
(43) Date de publication de la demande: **14.01.2026**
(21) Numéro de dépôt: 25184525.1
(22) Date de dépôt: 23.06.2025
(51) Int. Cl.: G01R 15/18, G01R 19/10

(54) **DISPOSITIF DE MESURE DE COURANTS PRINCIPAUX D'UNE INSTALLATION ÉLECTRIQUE, MÉTHODE DE MESURE ET MÉTHODE DE PROTECTION UTILISANT UN TEL DISPOSITIF**

(30) Priorité: 24.06.2024 FR 2406779
(71) Demandeur: SCHNEIDER ELECTRIC INDUSTRIES SAS, 92500 Rueil-Malmaison (FR)
(72) Inventeur: BORDET, Bruno, 92500 Rueil-Malmaison (FR); RONDOT, Loïc, 92500 Rueil-Malmaison (FR)
(74) Mandataire: Lavoix

(57) **Abrégé**

L'invention concerne un dispositif de mesure de courants principaux (1) d'une installation électrique comprenant N conducteurs (3). Le dispositif comprend un circuit magnétique fermé (5), au moins N-1 bobinages de mesure du courant principal (11), une structure de maintien (6), des moyens de mesure (13) d'une tension (V11) aux bornes des bobinages de mesure du courant principal (11) et une unité de calcul (15). Chaque bobinage de mesure du courant principal comprend deux enroulements en série (111, 112) qui sont enroulés chacun autour d'une partie du circuit magnétique (5), ne sont pas équidistants d'au moins un des conducteurs (3), et ont un sens d'enroulement opposé d'un enroulement (111, 112) à l'autre, de sorte qu'un champ magnétique uniforme dans le circuit magnétique (5) génère une tension qui s'annule aux bornes du bobinage de mesure du courant principal (11).

## Description

La présente invention concerne un dispositif de mesure de courants principaux d'une installation électrique. Elle concerne également une méthode de mesure de courants principaux d'une installation électrique utilisant un tel dispositif. Elle concerne également une méthode de protection d'une installation électrique utilisant un tel dispositif.

Il est utile de connaître les courants circulants dans chacun des fils de phase ou de neutre d'une installation électrique, appelés courants principaux, à des fins d'indication ou de protection. Pour cela, il est connu d'utiliser des capteurs de technologies diverses, telles que des capteurs CT, des shunts résistifs, des capteurs de Rogowski ou des capteurs à effet Hall.

Toutefois, la mesure des courants principaux par ces moyens nécessite d'installer plusieurs capteurs, généralement un par conducteur. De plus, ces capteurs viennent généralement s'ajouter à un capteur de mesure du courant différentiel. Cette multiplicité de capteurs dans l'installation entraîne un encombrement et un coût importants.

Le but de l'invention est alors de proposer un dispositif de mesure des courants principaux d'une installation électrique permettant de diminuer le nombre total de capteurs dans l'installation, afin d'obtenir un gain de place, un gain sur le coût des capteurs et sur le coût des assemblages.

A cet effet, l'invention a pour objet un dispositif de mesure de courants principaux d'une installation électrique comprenant un nombre N de conducteurs parcourus par un courant principal *I̅,* comprenant :
- un circuit magnétique fermé, composé d'un matériau ferromagnétique et configuré pour entourer les conducteurs ;
- au moins N-1 bobinages de mesure du courant principal, chaque bobinage de mesure du courant principal comprenant deux enroulements en série qui :
   i. sont enroulés chacun autour d'une partie du circuit magnétique fermé,
   ii. ne sont pas équidistants d'au moins un des conducteurs, de sorte que le courant principal *̅I̅*̅ circulant dans ledit au moins un conducteur génère un flux magnétique différent au niveau de chacun des deux enroulements, et
   iii. ont un sens d'enroulement opposé d'un enroulement à l'autre, de sorte qu'un champ magnétique uniforme dans le circuit magnétique génère une tension qui s'annule aux bornes du bobinage de mesure du courant principal ;
- une structure de maintien configurée pour maintenir les conducteurs dans une disposition donnée où les conducteurs ne sont pas coaxiaux ;
- des moyens de mesure d'une tension aux bornes des N-1 bobinages de mesure du courant principal ; et
- une unité de calcul, reliée aux moyens de mesure de la tension.

Grâce à l'invention, un seul capteur est nécessaire pour réaliser la mesure des courants circulant dans plusieurs conducteurs simultanément. En effet, puisque les conducteurs ne sont pas coaxiaux, les courants circulants dans différents conducteurs auront des influences différentes sur un champ magnétique résultant en un point donné du circuit magnétique. Ainsi, puisque les bobinages de mesure du courant principal sont localisés autour d'une partie du circuit magnétique, la tension générée aux bornes d'un bobinage de mesure du courant principal est dépendante des courants principaux. Ainsi, en mesurant les tensions aux bornes des bobinages de courant primaire, et grâce à la connaissance de la géométrie ou à une opération de calibrage, il est possible d'obtenir autant d'équations sur les courants principaux que de bobinages de mesure du courant primaire. Disposant des au moins N-1 équations ainsi obtenues, complétées éventuellement d'une équation supplémentaire résultant de l'égalité vectorielle des courants principaux d'une installation, il est possible de déduire la valeur de chaque courant principal, à partir de l'unique dispositif de mesure de courants principaux. Ce dispositif permet de s'affranchir de la multiplicité de capteurs de mesure du courant principal usuels, et donc d'obtenir un gain de place et de coûts en diminuant le nombre total de capteurs dans l'installation.

Suivant d'autres aspects avantageux de l'invention, le dispositif de mesure de courants principaux comprend une ou plusieurs des caractéristiques suivantes, prises isolément ou suivant toutes les combinaisons techniquement possibles :
- le circuit magnétique est de forme symétrique, c'est-à-dire comprend au moins un axe de symétrie et/ou un centre de symétrie ;
- l'au moins un axe de symétrie est aussi un axe de symétrie de la structure de maintien ;
- les deux enroulements de chaque bobinage de mesure du courant principal sont disposés de façon symétrique entre eux par rapport au centre de symétrie du circuit magnétique ou par rapport à l'au moins un axe de symétrie ;
- les conducteurs principaux sont au nombre de 2, l'un des conducteurs étant un fil de phase et l'autre étant un fil de neutre d'une installation électrique monophasée ou un autre fil de phase d'une installation électrique biphasée ;
- les conducteurs sont au nombre de 3, deux des trois conducteurs étant des fils de phase et le troisième conducteur étant un troisième fil de phase ou un fil de neutre d'une installation électrique ;
- les conducteurs sont au nombre de 4, trois des conducteurs étant des fils de phase et le quatrième étant un fil de neutre d'une installation électrique ;
- le dispositif comprend un bobinage de mesure du courant différentiel, enroulé de façon régulière autour du circuit magnétique fermé, et un moyen de mesure d'un courant circulant dans le bobinage de mesure du courant différentiel, relié à l'unité de calcul ou à une autre unité de calcul.

L'invention concerne également une méthode de mesure de courants principaux d'une installation électrique, mise en œuvre par l'unité de calcul d'un dispositif de mesure de courants principaux conforme à ce qui précède et comprenant des étapes consistant à :
- recevoir des valeurs de la tension aux bornes de chaque bobinage de mesure du courant principal, mesurées par les moyens de mesure de tension ;
- convertir les valeurs de la tension aux bornes de chaque bobinage de mesure du courant principal en valeurs de courants principaux, correspondant aux courants circulants dans les conducteurs principaux ; puis
- restituer les valeurs de courants principaux sous forme analogique ou numérique.

L'invention concerne également une méthode de protection d'une installation électrique, l'installation électrique présentant un courant de fuite défini comme une différence entre la somme des courants principaux entrants dans l'installation électrique et la somme des courants principaux sortants de l'installation électrique, la méthode étant mise en œuvre par l'unité de calcul d'un dispositif de mesure de courant principaux selon l'invention, comprenant des étapes consistant à :
- recevoir une valeur du courant circulant dans le bobinage de mesure du courant différentiel, mesuré par le moyen de mesure du courant ;
- en déduire, grâce à un coefficient de proportionnalité obtenu par calibration préalable, la valeur du courant de fuite ; puis
- commander un interrupteur permettant d'interrompre une alimentation de l'installation électrique si et seulement si la valeur du courant de fuite est supérieure à une valeur seuil prédéterminée.

L'invention apparaîtra plus clairement à la lecture de la description qui va suivre, donnée uniquement à titre d'exemple non limitatif, et faite en référence aux dessins dans lesquels :
[Fig. 1] la figure 1 est un schéma d'ensemble d'un dispositif de mesure de courants principaux selon l'invention, dans le cas d'une installation à deux conducteurs selon un premier mode de réalisation de l'invention,
[Fig. 2] la figure 2 est un schéma d'une partie d'un dispositif de mesure de courants principaux selon l'invention, dans le cas d'une installation à deux conducteurs selon un deuxième mode de réalisation de l'invention,
[Fig. 3] la figure 3 est un schéma d'une partie d'un dispositif de mesure de courants principaux selon l'invention, dans le cas d'une installation à trois conducteurs,
[Fig. 4] la figure 4 est un schéma d'une partie d'un dispositif de mesure de courants principaux selon l'invention, dans le cas d'une installation tétrapolaire.

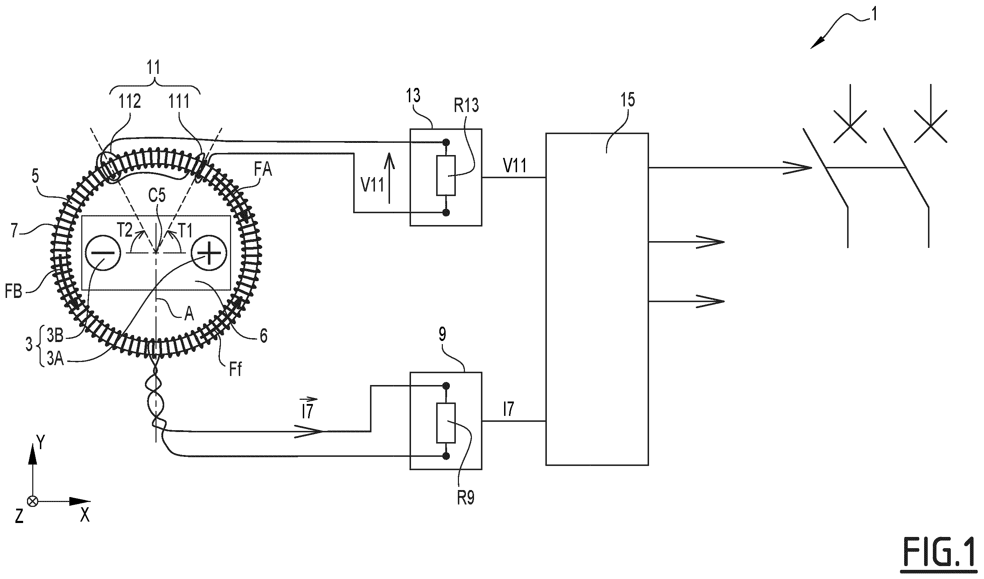

Le dispositif de mesure de courants principaux 1 représenté à la figure 1 est intégré à une entrée d'une installation électrique, où sont habituellement disposés des disjoncteurs et des capteurs de mesure de courant. Pour faciliter la compréhension, on se limite dans un premier temps à la description d'une installation électrique monophasée. L'installation est alors alimentée par deux fils conducteurs, appelés conducteurs 3, dans lesquels circulent des courants principaux *̅I̅*̅. Le premier conducteur 3A est un fil de phase, par lequel un premier courant principal *̅I̅A̅*̅ entre dans l'installation électrique. Le deuxième conducteur 3B est un fil de neutre, par lequel un deuxième courant principal *̅I̅B̅*̅ sort de l'installation électrique. Les conducteurs 3 alimentent un ensemble d'appareils électriques appartenant à l'installation électrique.

En l'absence d'anomalie, les courants principaux *̅I̅A̅*̅ et *̅I̅B̅*̅ sont égaux en valeur absolue. En cas d'anomalie dans l'installation électrique, il existe un courant de fuite *̅I̅f̅*̅ dans l'installation électrique, également appelé courant différentiel, tel que *I̅A̅= I̅B̅+ I̅f̅.* Le courant de fuite *̅I̅f̅*̅ est une source potentielle de danger pour des utilisateurs de l'installation électrique ou pour les appareils électriques précités. La valeur du courant de fuite *̅I̅f̅*̅ est généralement faible devant les valeurs des courants principaux *̅I̅A̅*̅ et *I̅B̅.*

Le dispositif de mesure de courants principaux 1 a pour fonction de mesurer les valeurs des courants principaux *̅I̅A̅*̅ et *I̅B̅,* à des fins d'indication ou de protection. En particulier, la mesure des courants principaux *̅I̅A̅*̅ et *̅I̅B̅*̅ est utile pour surveiller la consommation électrique de l'installation.

Avantageusement, et dans l'exemple de la figure 1, le dispositif de mesure de courants principaux 1 a également pour fonction de mesurer le courant de fuite *I̅f̅.* Cette mesure est utile pour protéger l'installation électrique en interrompant l'alimentation en cas de présence d'un courant de fuite *I̅f̅,* selon le principe connu d'un disjoncteur différentiel.

Pour cela, le dispositif de mesure de courants principaux 1 comprend un circuit magnétique 5, une structure de maintien 6, un bobinage de mesure du courant différentiel 7, un moyen de mesure de courant 9, un bobinage de mesure du courant principal 11, un moyen de mesure de tension 13 et une unité de calcul 15.

Le circuit magnétique 5 entoure les conducteurs 3. Autrement dit, les conducteurs 3 traversent le circuit magnétique 5. Le circuit magnétique 5 s'étend dans un plan (x,y) représenté sur les figures 1 à 4. Ce circuit magnétique est fermé et composé d'un matériau ferromagnétique, de sorte qu'un flux magnétique F puisse y circuler. Le circuit magnétique 5 est avantageusement de forme symétrique, c'est-à-dire qu'il comprend au moins un axe de symétrie A et/ou un centre de symétrie C5. L'axe de symétrie A est défini comme l'intersection du plan (x,y) avec un plan de symétrie du circuit magnétique 5, de préférence perpendiculaire au plan (x,y). Ainsi, l'axe de symétrie A est perpendiculaire à l'axe z, donc aux conducteurs 3, et est contenu dans le plan (x,y), c'est-à-dire dans le plan du circuit magnétique 5. Le circuit magnétique 5 représenté sur la figure 1 est de forme circulaire de centre C5, ce qui permet d'optimiser la compacité et la quantité de matière du dispositif 1.

En variante non-représentée de l'invention, le circuit magnétique 5 peut être de forme oblongue, rectangulaire ou quelconque.

De préférence, les conducteurs 3 sont maintenus par la structure de maintien 6 dans une position où ils sont perpendiculaires au circuit magnétique 5. En d'autres termes, les conducteurs 3 s'étendent parallèlement à un axe z normal au plan (x,y).

La structure de maintien 6 est solidaire du circuit magnétique 5 et maintient les conducteurs 3 dans une disposition donnée dans laquelle ils ne sont pas coaxiaux. A titre d'exemple, la structure de maintien peut être un cavalier en matériau isolant que traversent les conducteurs 3 et qui est disposé au voisinage du circuit magnétique 5, sans être forcément coplanaire avec ce circuit.

Avantageusement, l'axe de symétrie A précité est également un axe de symétrie de la structure de maintien 6. En d'autres termes, l'ensemble constitué de la structure de maintien 6 et du circuit magnétique 5 définit au moins un axe de symétrie A.

Le bobinage de mesure du courant différentiel 7 est, de façon connue, enroulé de façon régulière autour du circuit magnétique 5. En fonctionnement, les courants principaux *̅I̅A̅*̅ et *̅I̅B̅*̅circulant dans les conducteurs 3A et 3B génèrent des flux magnétiques FA et FB dans le circuit magnétique 5. Puisque les courants principaux *̅I̅A̅*̅ et *̅I̅B̅*̅ sont de sens opposés, les flux magnétiques FA et FB sont de sens opposés.

En l'absence d'anomalie, les courants principaux *̅I̅A̅*̅ et *̅I̅B̅*̅ étant de même valeur et de sens opposés, il en est de même pour les flux magnétiques FA et FB, qui s'annulent alors dans le circuit magnétique 5 et ne sont pas perceptibles par le bobinage de courant différentiel 7 par équilibre et symétrie.

En cas d'anomalie, les courants principaux *̅I̅A̅*̅ et *̅I̅B̅*̅ n'étant plus de même valeur, il existe dans le circuit magnétique 5 un flux magnétique différentiel Ff résultant de la différence entre les flux magnétiques FA et FB, donc de la différence entre les courants principaux *̅I̅A̅*̅ et *I̅B̅,* donc du courant de fuite *I̅f̅.* Ce flux magnétique différentiel Ff génère un courant résultant *̅I̅7̅*̅ dans le bobinage de courant différentiel 7. En d'autres termes, le courant résultant *̅I̅7̅*̅ dans le bobinage de courant différentiel 7 est proportionnel au courant de fuite *̅I̅f̅*̅ et indépendant des courants principaux *̅I̅A̅*̅ et *̅I̅B̅*̅.Le bobinage de mesure du courant différentiel 7 forme un circuit en série avec le moyen de mesure de courant 9. Le moyen de mesure de courant 9 est typiquement un ampèremètre et possède une résistance interne d'ampèremètre R9 très faible, par exemple inférieure à 100Ω. Ainsi, le bobinage de mesure du courant différentiel 7 est quasiment en court-circuit, de sorte que le fonctionnement en transformateur de courant du bobinage de mesure du courant différentiel 7 n'est que très peu ou pas impacté par le moyen de mesure du courant 9.

Le moyen de mesure de courant 9 mesure ainsi le courant *̅I̅7̅*̅ circulant dans le bobinage de mesure du courant différentiel 7. D'après ce qui précède, le moyen de mesure du courant 9 mesure donc un courant proportionnel au courant de fuite *̅I̅f̅*̅ et indépendant des courants principaux *̅I̅A̅*̅ et *I̅B̅.*

Les bobinages de mesures du courant principal 11 sont au moins au nombre de N-1, où N est le nombre de conducteurs 3. Dans le mode de réalisation considéré à la figure 1, où N est égal à 2, le dispositif de mesure de courants principaux 1 comprend un unique bobinage de mesure du courant principal 11.

Le bobinage de mesure du courant principal 11 comprend deux enroulements 111 et 112. Comme visible sur la figure 1, les deux enroulements 111 et 112 sont raccordés en série et sont chacun enroulé autour d'une partie du circuit magnétique 5. Les deux enroulements 111 et 112 ne sont pas équidistants de l'un et/ou l'autre des conducteurs 3A et 3B, c'est-à-dire qu'il existe au moins un conducteur 3A ou 3B tel que la distance du premier enroulement 111 à ce conducteur 3A ou 3B est différente de la distance du deuxième enroulement 112 à ce conducteur 3A ou 3B. Ainsi, le courant principal *̅I̅A̅*̅ ou *̅I̅B̅*̅ circulant dans ce conducteur 3A ou 3B génère un flux magnétique différent au niveau de chacun des deux enroulements 111 et 112. Cela est possible grâce à la disposition précitée, assurée par la structure de maintien 6, disposition dans laquelle les conducteurs 3 ne sont pas coaxiaux. Dans l'exemple de la figure 1, les deux enroulements 111 et 112 ne sont pas équidistants du conducteur 3A, et ne sont pas non plus équidistants du conducteur 3B.

Ainsi, les flux magnétiques FA et FB générés par les courants principaux *̅I̅A̅*̅ et *̅I̅B̅*̅ circulant dans les conducteurs 3A et 3B ont une influence différente sur un flux magnétique résultant au niveau d'un enroulement 111 ou 112. En particulier, dans la disposition représentée à la figure 1, le premier enroulement 111 est plus proche du conducteur primaire 3A que le deuxième enroulement 112. En conséquence, le courant principal *̅I̅A̅*̅ a une contribution plus grande sur le flux magnétique résultant au niveau du premier enroulement 111 que sur le flux magnétique résultant au niveau du second enroulement 112.. De même, le courant principal *̅I̅B̅*̅ a une contribution plus grande sur le flux magnétique résultant au niveau du second enroulement 112 que sur le flux magnétique résultant au niveau du premier enroulement 111.

On définit l'angle orienté T1 entre une droite passant par les centres des conducteurs 3A et 3B et une droite passant par le centre de symétrie C5 du circuit magnétique 5 et par la position du premier enroulement 111 sur le circuit magnétique 5. De même, on définit l'angle orienté T2 entre la droite passant par les centres des conducteurs 3A et 3B et une droite passant par le centre de symétrie C5 du circuit magnétique 5 et par la position du second enroulement 112.

Dans le premier mode de réalisation représenté à la figure 1, les deux enroulements 111 et 112 de chaque bobinage de mesure du courant principal 11 sont disposés de façon symétrique entre eux par rapport à l'axe de symétrie A. Dit autrement, les angles T1 et T2 sont de valeur absolue égale et de sens opposé.

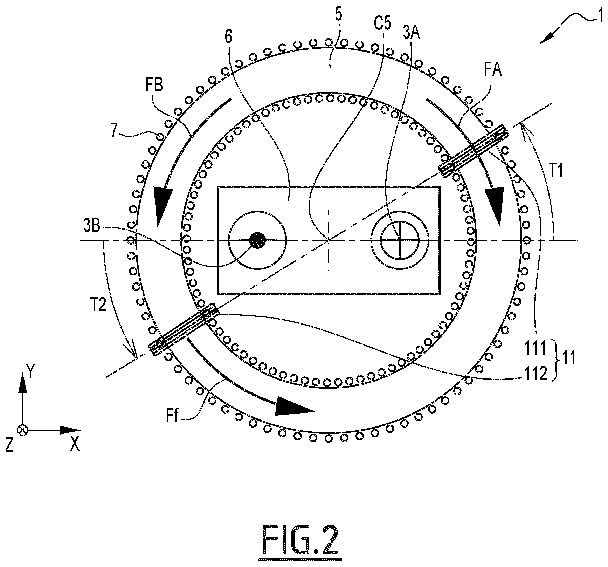

Dans le second mode de réalisation de l'invention représenté à la figure 2, les deux enroulements 111 et 112 de chaque bobinage de mesure du courant principal 11 sont disposés de façon symétrique entre eux par rapport au centre C5 du circuit magnétique 5. Dit autrement, les angles T1 et T2 sont égaux.

Cette symétrie est avantageuse à des fins de simplification mais n'est pas une caractéristique strictement indispensable de l'invention. En effet, pour un nombre de conducteurs 3 et une géométrie du circuit magnétique 5 quelconques, une simulation numérique peut permettre de définir une position optimale des deux enroulements 111 et 112 du bobinage de mesure du courant principal 11. Cependant, le positionnement optimal des deux enroulements 111 et 112 est facilité par la présence de l'axe de symétrie A et/ou du centre de symétrie C5. Les deux enroulements 111 et 112 sont alors positionnés de manière optimale en étant eux même symétriques entre eux par rapport à l'axe de symétrie A ou par rapport au centre de symétrie C5.

Dans les deux modes de réalisation des figures 1 et 2, les deux enroulements 111 et 112 ont en outre un sens d'enroulement opposé. Ainsi, le flux magnétique différentiel Ff, uniforme dans le circuit magnétique 5, génère une tension résultante de sens opposé aux bornes de chacun des deux enroulements 111 et 112. Puisque ces deux enroulements sont en série, ces contributions s'annulent, de sorte que la tension résultante V11 aux bornes du bobinage de mesure du courant principal 11 est indépendante du flux différentiel Ff, et donc du courant de fuite *I̅f̅.*

Pour la même raison, le flux magnétique résultant au niveau du premier enroulement 111, qui résulte majoritairement du flux magnétique FA généré par le courant principal *̅I̅A̅*̅, et le flux magnétique résultant au niveau du second enroulement 112, qui résulte majoritairement du flux magnétique FB, généré par le courant principal *̅I̅B̅*̅ et de sens opposé au flux magnétique FA, génèrent dans les enroulements 111 et 112 des tensions qui s'ajoutent sans se compenser. Ainsi, la tension résultante V11 aux bornes du bobinage de mesure du courant principal 11 dépend des courants principaux *̅I̅A̅*̅ et *̅I̅B̅*̅ en étant indépendante du courant de fuite *I̅f̅.*

Comme expliqué ci-dessus, la présence des deux enroulements en série 111 et 112 de sens d'enroulement opposés permet de rendre la mesure des courants principaux *̅I̅A̅*̅ et *̅I̅B̅*̅ indépendante du courant de fuite *I̅f̅.* Cette caractéristique est essentielle car le courant de fuite *I̅f̅,* bien que faible devant les courants principaux *̅I̅A̅*̅ et *I̅B̅,* génère dans le circuit magnétique 5 un flux magnétique différentiel Ff qui est prédominant par rapport aux flux magnétiques FA et FB.

Le bobinage de mesure du courant principal 11 forme un circuit en série avec le moyen de mesure de tension 13. Le moyen de mesure de tension 13 est typiquement un voltmètre et possède une résistance interne de voltmètre R13 élevée, par exemple supérieure à 1MΩ. Ainsi la mesure des courants principaux n'influence pas, ou de façon négligeable, la mesure du courant différentiel *I̅f̅.*

Le moyen de mesure de tension 13 mesure ainsi la tension résultante V11 aux bornes du bobinage de mesure du courant principal 11. D'après ce qui précède, le moyen de mesure de tension 13 mesure donc une tension dépendante des courants principaux *̅I̅A̅*̅ et *̅I̅B̅*̅ et indépendante du courant de fuite *I̅f̅.*

L'unité de calcul 15 reçoit la mesure du courant *̅I̅7̅*̅ fournie par le moyen de mesure de courant 9 et la mesure de la tension V11 fournie par le moyen de mesure de tension 13, afin d'en déduire une valeur de courant différentiel *̅I̅f̅*̅ et des valeurs de courants principaux *̅I̅A̅*̅ et *I̅B̅.*

Comme expliqué précédemment, le valeur du courant *̅I̅7̅*̅ est proportionnelle à la valeur du courant de fuite *I̅f̅.* Grâce à une étape de calibration préalable, l'unité de calcul 15 convertit donc simplement la mesure du courant *̅I̅7̅*̅ en valeur de courant différentiel *I̅f̅.* L'unité de calcul 15 restitue la valeur de courant différentiel *̅I̅f̅*̅ sous forme analogique ou numérique ou l'exploite pour commander ou non l'interruption de l'alimentation de l'installation électrique.

Comme expliqué précédemment, la tension V11 dépend des valeurs de courants principaux *̅I̅A̅*̅ et *I̅B̅.* Connaissant la géométrie du dispositif de mesure de courants principaux 1, et en particulier la disposition des conducteurs 3 fixée par le dispositif de maintien 6, ou bien grâce à une étape de calibration, l'unité de calcul 15 convertit la mesure de la tension V11 en une équation sur les courants principaux *̅I̅A̅*̅ et *I̅B̅.* Puisque le courant de fuite *̅I̅f̅*̅ est faible devant les valeurs des courants principaux *̅I̅A̅*̅ et *I̅B̅,* on peut, pour cette mesure, faire l'approximation que les courants *̅I̅A̅*̅ et *̅I̅B̅*̅ sont égaux. Cette égalité fournit une deuxième équation sur les courants principaux *̅I̅A̅*̅ et *I̅B̅.* En variante non représentée, la deuxième équation sur les courants principaux *̅I̅A̅*̅ et *̅I̅B̅*̅ peut être issue d'un raisonnement similaire sur un bobinage de mesure du courant principal supplémentaire. A partir des deux équations sur les courants principaux *̅I̅A̅*̅ et *I̅B̅,* l'unité de calcul 15 détermine les valeurs de chaque courant principal *̅I̅A̅*̅ et *̅I̅B̅*̅ et restitue ces valeurs sous forme analogique ou numérique.

En variante non représentée, le dispositif de mesure de courants principaux 1 comprend deux unités de calcul distinctes, l'une des deux unités de calcul recevant la mesure du courant *̅I̅7̅*̅ et réalisant la conversion de la mesure du courant *̅I̅7̅*̅ et l'autre des deux unités de calcul recevant la mesure de la tension V11 et réalisant la conversion de la mesure de la tension V11.

En variante, l'installation électrique est une installation électrique biphasée et les deux conducteurs 3A et 3B sont deux fils de phase.

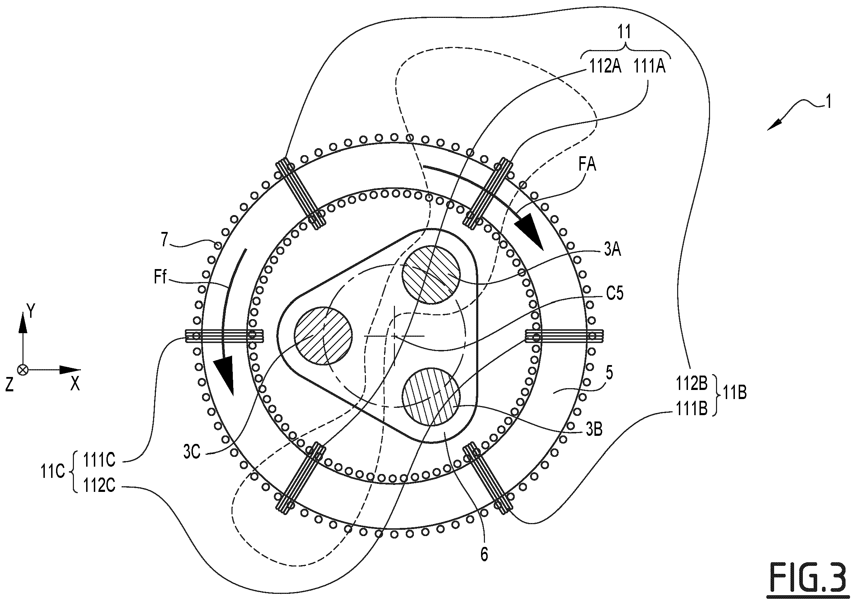

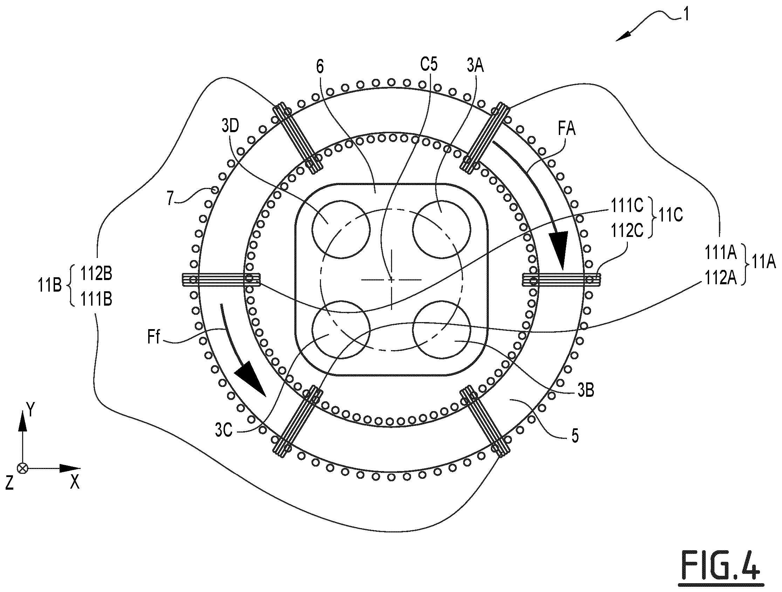

Les figures 3 et 4 représentent une généralisation de l'exemple ci-dessus aux cas d'une installation électrique respectivement à trois conducteurs et à quatre conducteurs. Dans les modes de réalisation des figures 3 et 4, les éléments analogues à ceux du premier mode de réalisation portent les mêmes références. Si une référence est mentionnée dans la suite de la description sans être portée sur l'une des figures 3 et 4 ou portée sur l'une de ces figures sans être mentionnée dans la suite de la description, elle correspond à l'élément portant la même référence dans le premier mode de réalisation. Dans ce qui suit, on décrit principalement les différences entre l'exemple de l'installation monophasée et la généralisation à trois conducteurs et au tétrapolaire.

Dans le cas d'une installation à trois conducteurs représentée à la figure 3, les conducteurs principaux sont notés 3A, 3B et 3C et les courants principaux circulant dans ces conducteurs 3A, 3B et 3C sont notés respectivement *I̅A̅, I̅B̅* et *I̅C̅.* L'installation électrique est par exemple triphasée et les conducteurs 3A, 3B et 3C sont alors trois fils de phase. En variante, deux des trois conducteurs 3A et 3B sont des fils de phase et le troisième conducteur 3C est un fil de neutre.

Les bobinages de mesure du courant principal 11 sont alors au moins au nombre de deux. Sur la figure 3, trois bobinages de mesure du courant principal 11A, 11B et 11C sont représentés. Comme visible sur la figure 3, les deux enroulements 111 et 112 de chaque bobinage de mesure du courant principal 11 sont avantageusement symétriques entre eux par rapport au centre de symétrie C5 du circuit magnétique 5, comme dans le mode de réalisation de la figure 2.

Les deux enroulements du premier bobinage de mesure du courant principal 11A sont notés 111A et 112A, Les deux enroulements du deuxième bobinage de mesure du courant principal 11B sont notés 111B et 112B et les deux enroulements du troisième bobinage de mesure du courant principal 11C sont notés 111C et 112C.

Dans ce cas, trois équations à trois inconnues *I̅A̅, I̅B̅* et *̅I̅C̅*̅ sont obtenues et résolues par l'unité de calcul 15, fournissant les trois valeurs de courant principal *I̅A̅, I̅B̅* et *I̅C̅.*

Dans le cas d'une installation tétrapolaire, les conducteurs sont au nombre de quatre : trois fils de phase 3A, 3B et 3C et un fil de neutre 3D, dans lesquels circulent des courants principaux respectifs *I̅A̅, I̅B̅, I̅C̅* et *̅I̅D̅*̅. Dans l'exemple illustré à la figure 4, le dispositif 1 est alors similaire au cas à trois conducteurs et la quatrième équation sur les courants principaux provient de l'approximation *I̅A̅ + I̅B̅ + I̅C̅ = I̅D̅.*

Les enroulements 111A, 112A, 111B, 112B, 111C et 112C des bobinages de mesure du courant principal 11A, 11B et 11C sont repérés comme dans le mode de réalisation de la figure 3.

Un moyen de mesure de tension non représenté, du type du moyen de mesure de tension 13, est monté en série avec chaque bobinage de mesure du courant principal 11A, 11B et 11C et permet de mesurer une tension du type de la tension V11.

La mise en œuvre d'une méthode de mesure de courants principaux d'une installation électrique au moyen d'un dispositif de mesure de courants principaux 1 conforme à ce qui précède, après une éventuelle opération de calibration, est décrite dans la suite de la description.

En fonctionnement, les courants principaux *̅I̅*̅ circulant dans les N conducteurs 3 génèrent des flux magnétiques F dans le circuit magnétique 5, lesquels flux magnétiques génèrent à leur tour un courant *̅I̅7̅*̅ résultant dans le bobinage de mesure du courant différentiel 7 et des tensions V11 et équivalentes aux bornes des bobinages de mesure du courant principal 11, 11A, 11B et 11C.

Comme expliqué précédemment, du fait de la géométrie du dispositif de mesure de courants principaux 1, le courant *̅I̅7̅*̅ résultant dans le bobinage de mesure du courant différentiel 7 est proportionnel au courant de fuite *̅I̅f̅*̅ en étant indépendant des courants principaux *̅I̅*̅.

De même, les tensions résultantes V11 et équivalentes aux bornes des bobinages de mesure du courant principal 11, 11A, 11B et 11C, sont dépendantes des courants principaux *̅I̅*̅ en étant indépendantes du courant de fuite *I̅f̅.*

La méthode de mesure des courants principaux, mise en œuvre par l'unité de calcul 15 consiste alors à :
- recevoir des valeurs de la tension V11 aux bornes de chaque bobinage de mesure du courant principal 11, mesurées par les moyens de mesure de tension 13 ;
- en déduire, grâce à la connaissance de la géométrie du dispositif de mesure de courants principaux 1 ou de la calibration préalable, les au moins N-1 équations sur les courants principaux *̅I̅*̅ ;
- éventuellement, compléter avec une équation issue de l'approximation d'égalité vectorielle des courants principaux d'une installation électrique ;
- résoudre le système de N équations dont les N inconnues sont les N courants principaux *̅I̅*̅ ;
- restituer les valeurs de courants principaux *̅I̅*̅ sous forme analogique ou numérique.

Avantageusement, l'unité de calcul 15 met en parallèle en œuvre la méthode de protection de l'installation qui consiste à :
- recevoir une valeur I7 du courant *̅I̅7̅*̅ circulant dans le bobinage de mesure du courant différentiel 7, mesuré par le moyen de mesure du courant 9 ;
- en déduire, grâce à un coefficient de proportionnalité obtenu par calibration préalable, la valeur du courant de fuite *̅I̅f̅*̅ ;
- commander un interrupteur permettant d'interrompre l'alimentation de l'installation électrique si et seulement si la valeur du courant de fuite *̅I̅f̅*̅ est supérieure à une valeur seuil prédéterminée.

Ainsi, les courants principaux *̅I̅*̅ des conducteurs 3 de l'installation électrique sont mesurés au moyen de l'unique dispositif de mesure de courants principaux 1, tout en assurant la fonction de protection d'un disjoncteur différentiel.

Toute caractéristique décrite ci-dessus pour un mode de réalisation ou une variante, peut être mise en œuvre également dans les autres modes de réalisation ou variantes décrit ci-dessus, pour autant que techniquement possible.

## Revendications

1. Dispositif de mesure de courants principaux (1) d'une installation électrique comprenant un nombre N de conducteurs (3) parcourus par un courant principal *̅I̅*̅, **caractérisé en ce que** le dispositif comprend :
- un circuit magnétique fermé (5), composé d'un matériau ferromagnétique et configuré pour entourer les conducteurs (3) ;
- au moins N-1 bobinages de mesure du courant principal (11), chaque bobinage de mesure du courant principal comprenant deux enroulements en série (111, 112) qui :
i. sont enroulés chacun autour d'une partie du circuit magnétique fermé (5),
ii. ne sont pas équidistants d'au moins un des conducteurs (3), de sorte que le courant principal *̅I̅*̅ circulant dans ledit au moins un conducteur génère un flux magnétique différent au niveau de chacun des deux enroulements (111,112), et
iii. ont un sens d'enroulement opposé d'un enroulement (111, 112) à l'autre, de sorte qu'un champ magnétique uniforme dans le circuit magnétique (5) génère une tension qui s'annule aux bornes du bobinage de mesure du courant principal (11) ;
- une structure de maintien (6) configurée pour maintenir les conducteurs (3) dans une disposition donnée où les conducteurs (3) ne sont pas coaxiaux ;
- des moyens de mesure (13) d'une tension (V11) aux bornes des N-1 bobinages de mesure du courant principal (11) ; et
- une unité de calcul (15), reliée aux moyens de mesure (13) de la tension (V11).

2. Dispositif (1) selon la revendication 1, dans lequel le circuit magnétique (5) est de forme symétrique, c'est-à-dire comprend au moins un axe de symétrie (A) et/ou un centre de symétrie (C5).

3. Dispositif (1) selon la revendication 2, dans lequel l'au moins un axe de symétrie (A) est aussi un axe de symétrie de la structure de maintien (6).

4. Dispositif (1) selon la revendication 2 ou 3, dans lequel les deux enroulements (111, 112) de chaque bobinage de mesure du courant principal (11) sont disposés de façon symétrique entre eux par rapport au centre de symétrie (C5) du circuit magnétique (5) ou par rapport à l'au moins un axe de symétrie (A).

5. Dispositif (1) selon la revendication 4, dans lequel les conducteurs principaux (3) sont au nombre de 2, l'un des conducteurs étant un fil de phase (3A) et l'autre étant un fil de neutre (3B) d'une installation électrique monophasée ou un autre fil de phase (3B) d'une installation électrique biphasée.

6. Dispositif (1) selon la revendication 4, dans lequel les conducteurs (3) sont au nombre de 3, deux des trois conducteurs (3A, 3B) étant des fils de phase et le troisième conducteur (3C) étant un troisième fil de phase ou un fil de neutre d'une installation électrique.

7. Dispositif (1) selon la revendication 4, dans lequel les conducteurs (3) sont au nombre de 4, trois des conducteurs étant des fils de phase (3A, 3B, 3C) et le quatrième étant un fil de neutre (3D) d'une installation électrique.

8. Dispositif (1) selon l'une des revendications précédentes, comprenant :
- un bobinage de mesure du courant différentiel (7), enroulé de façon régulière autour du circuit magnétique fermé (5), et
- un moyen de mesure (9) d'un courant (*̅I̅7̅*̅) circulant dans le bobinage de mesure du courant différentiel (7), relié à l'unité de calcul (15) ou à une autre unité de calcul.

9. Méthode de mesure de courants principaux d'une installation électrique, mise en œuvre par l'unité de calcul (15) d'un dispositif de mesure de courants principaux (1) selon l'une des revendications précédentes, comprenant des étapes consistant à :
- recevoir des valeurs de la tension (V11) aux bornes de chaque bobinage de mesure du courant principal (11), mesurées par les moyens de mesure de tension (13) ;
- convertir les valeurs de la tension (V11) aux bornes de chaque bobinage de mesure du courant principal (11) en valeurs de courants principaux, correspondant aux courants circulants dans les conducteurs principaux (3) ; puis
- restituer les valeurs de courants principaux sous forme analogique ou numérique.

10. Méthode de protection d'une installation électrique, l'installation électrique présentant un courant de fuite (*̅I̅f̅*̅) défini comme une différence entre la somme des courants principaux entrants dans l'installation électrique et la somme des courants principaux sortants de l'installation électrique, la méthode étant mise en œuvre par l'unité de calcul (15) d'un dispositif de mesure de courant principaux (1) selon la revendication 7, comprenant des étapes consistant à :
- recevoir une valeur (I7) du courant (*̅I̅7̅*̅) circulant dans le bobinage de mesure du courant différentiel (7), mesuré par le moyen de mesure du courant (9) ;
- en déduire, grâce à un coefficient de proportionnalité obtenu par calibration préalable, la valeur du courant de fuite (*̅I̅f̅*̅) ; puis
- commander un interrupteur permettant d'interrompre une alimentation de l'installation électrique si et seulement si la valeur du courant de fuite (*̅I̅f̅*̅) est supérieure à une valeur seuil prédéterminée.
